# EUROPÄISCHE PATENTANMELDUNG

(11) **EP 2 631 025 A1**
(43) Veröffentlichungstag der Anmeldung: **28.08.2013**
(21) Anmeldenummer: 12156660.8
(22) Anmeldetag: 23.02.2012
(51) Int. Cl.: B22F 9/12, B22F 9/30, B22F 1/00, C23C 4/08, C23C 4/12, C23C 14/00, C23C 14/14, C23C 14/22, C23C 16/06, C23C 16/513, C04B 35/58, C04B 35/56

(54) **Plasmaspritzverfahren**

(71) Anmelder: Forschungszentrum Jülich GmbH, 52428 Jülich (DE); Sulzer Metco AG, 5610 Wohlen (CH)
(72) Erfinder: Hospach, Andreas, 52428 Jülich (DE); Vassen, Robert, Prof. Dr., 52134 Herzogenrath (DE); Mauer, Georg, Dr., 47918 Tönisvorst (DE); Rauwald, Karl-Heinz, D-52428 Jülich (DE); Stöver, Detlev, Prof. Dr., 52382 Niederzier (DE); von Niessen, Konstantin, Dr., 5632 Buttwil (CH); Gindrat, Malko, Dr., 5610 Wohlen (CH)
(74) Vertreter: Sulzer Management AG

(57) **Zusammenfassung**

Die Erfindung betrifft ein Plasmaspritzverfahren, welches als Ausgangspunkt für eine Herstellung von Metall-, Nitrid- oder Carbid-Nanopulver oder Metall-, Nitrid- oder Carbid-Schichten dienen kann. Um eine kostengünstige Herstellung des Nanopulver oder der Schicht zu erreichen, wird beim erfindungsgemässen Plasmaspritzverfahren ein Ausgangsmaterial (P), welches ein Metalloxid enthält, bei einem Prozessdruck von höchstens 1000 Pa, insbesondere höchstens 400 Pa, in einen Plasmastrahl (113) eingebracht. Das Ausgangsmaterial (P) enthält ein Metalloxid, welches im Plasmastrahl (113) verdampft und dabei reduziert wird. Nach der Reduktion liegt damit das Metall, das im Ausgangsmaterial das Metalloxid gebildet hat, in oder nahezu in Reinform vor. Das Metall kann in Form von Nanopulver oder einer Schicht (124) abgeschieden werden. Durch Zugabe eines Stickstoff oder Kohlenstoff enthaltenden Reaktionsstoffs (R) können auch Nitrid- oder Carbid-Nanopartikel oder Schichten kostengünstig erzeugt werden.

## Beschreibung

Die Erfindung betrifft ein Plasmaspritzverfahren gemäß Anspruch 1.

Es ist bekannt, dass Nitrid- oder Carbid-Nanopulver unter Verwendung von geeigneten flüssigen oder gasförmigen Ausgangsstoffen, so genannter Precursoren hergestellt werden können. Unter einem Nanopulver soll in diesem Zusammenhang ein Pulver mit einer Korngrösse von ca. 1 nm bis 1 µm verstanden werden Geeignete Precursoren, beispielsweise Titantetrachlorid oder Tetrakis-dimethylamino-Titan, sind sehr teuer und meist sehr giftig bzw. gefährlich. Die Precursoren werden zur Herstellung des Nanopulvers verdampft und bilden in einem reaktiven chemischen Gasphasenabscheidungsprozess (einem so genannten CVD-Prozess) Nanopulver. Es ist auch möglich, mit einem vergleichbaren Verfahren eine Nitrid- oder Carbidbeschichtung auf einem Substrat herzustellen.

Ausserdem sind so genannte Plasmaspritz-Gasphasenabscheidungsverfahren (so genannte PS-PVD Verfahren) bekannt, mittels welchen aus einem Ausgangsangsmaterial in Pulverform Schichten auf einem Substrat erzeugt werden können. Das Ausgangsmaterial wird dazu in ein Plasma eingebracht und damit in die Gasphase überführt und aus der Gasphase als dünne Schicht auf dem Substrat abgeschieden. Beispielsweise werden auf diese Weise Wärmedämmschichten erzeugt. Als nichtmetallischer, anorganischer Ausgangsstoff dient dabei beispielsweise yttriumoxid-stabilisiertes Zirconiumoxid (abgekürzt YSZ).

Demgegenüber ist es die Aufgabe der Erfindung, ein Plasmaspritzverfahren vorzuschlagen, welches als Ausgangspunkt für eine kostengünstige Herstellung von Metall-, Nitrid- oder Carbid-Nanopulver oder Metall-, Nitrid- oder Carbid-Schichten dienen kann. Erfindungsgemäß wird diese Aufgabe mit einem Plasmaspritzverfahren mit den Merkmalen des Anspruchs 1 gelöst.

Beim erfindungsgemässen Plasmaspritzverfahren wird ein Ausgangsmaterial bei einem Prozessdruck von höchstens 1000 Pa, insbesondere höchstens 400 Pa, in einen von einem Plasmagenerator erzeugten Plasmastrahl eingebracht. Das Ausgangsmaterial enthält ein Metalloxid, welches im Plasmastrahl verdampft und dabei reduziert wird. Nach der Reduktion liegt damit das Metall, das im Ausgangsmaterial das Metalloxid gebildet hatte, in oder nahezu in Reinform vor.

Unter dem Begriff "Prozessdruck" soll der Druck verstanden werden, bei dem der Prozess abläuft, sich also der Plasmastrahl ausbildet. Da der notwendige Prozessdruck deutlich kleiner ist als der Atmosphärendruck, findet der ganze Prozess in einer abgeschlossenen Prozesskammer statt, in der der Prozessdruck eingestellt werden kann.

Das Ausgangsmaterial besteht dabei insbesondere zu 95 % bis 100 %, besonders bevorzugt zu 100 % aus Metalloxid eines einzigen Metalls oder verschiedenen Metallen, insbesondere aus Zirconiumoxid, Hafniumoxid oder Titanoxid. Neben dem Metalloxid kann das Ausgangsmaterial beispielsweise noch andere Oxide, beispielsweise Siliziumoxid aufweisen.

Beim erfindungsgemässen Verfahren wird das Metalloxid enthaltende Ausgangsmaterial in einen von einem an sich bekannten Plasmabrenner erzeugten Plasmastrahl, beispielsweise ein Argon-Helium-Plasma injiziert und damit eingebracht. Das Ausgangsmaterial wird dabei insbesondere als Pulver in den Plasmastrahl eingebracht. Es kann beispielsweise als loses Pulver mittels eines Trägergases eingebracht werden. Das Trägergas ist beispielsweise als ein Edelgas, Edelgasgemisch oder Inertgas ausgeführt; Beispiele für Trägergase sind Argon oder ein Helium-Argon-Gemisch. Es ist aber auch möglich, dass das Ausgangsmaterial in einer Suspension, also als dispergiertes Pulver in einer Flüssigkeit, beispielsweise in Ethanol in den Plasmastrahl eingebracht wird.

Das dadurch entstehende Plasmagas dehnt sich in einer Düse des Plasmabrenners aufgrund der hohen Temperatur des Plasmas von 10.000 bis 20.000 Kelvin aus und beschleunigt auf Überschallgeschwindigkeit. Auf Grund des genannten niedrigen Prozessdrucks erfolgt eine Expansion des Plasmagases in eine Prozesskammer mit geringem Druck, wobei ein langer, großflächiger Plasmastrahl mit Expansions- und Kompressionszonen entsteht. Der Plasmastrahl weist insbesondere eine Länge zwischen 1 und 2,5 m auf. Im Plasmastrahl verdampft auf Grund der hohen Temperatur und des geringen Drucks das im Ausgangsmaterial enthaltende Metalloxid. Dabei kommt es auf Grund des niedrigen Partialdrucks des Sauerstoffs zu einem Sauerstoffverlust, also zu einer Reduktion des Metalloxids, so dass das Metall nach der Reduktion in oder nahezu in Reinform im Plasmastrom vorliegt.

Das Ausgangsmaterial wird insbesondere mit einer vergleichsweise niedrigen Zuführrate zugeführt und damit in das Plasma eingebracht. Die Zuführrate liegt insbesondere in einem Bereich zwischen 0,1 und 5 g/min. Damit kann erreicht werden, dass das gesamte oder nahezu das gesamte eingebrachte Metalloxid vollständig reduziert wird.

Die Gesamtflussrate des Prozessgases beträgt insbesondere zwischen 50 und 200 SLPM (Standardliter pro Minute) und besonders bevorzugt 90 bis 120 SLPM.

In Ausgestaltung der Erfindung wird ein zusätzlicher Reaktionsstoff in das Plasma eingebracht, so dass eine Reaktion zwischen dem reduzierten Metalloxid und dem Reaktionsstoff zu einem Reaktionsergebnisstoff ablaufen kann. Der Reaktionsstoff enthält insbesondere Stickstoff und/oder Kohlenstoff, so dass das bei der Reduktion entstehende reine Metall zu einem Metallnitrid und/oder einem Metallcarbid reagieren kann. Damit ist es vorteilhafterweise möglich, aus einem sehr kostengünstigen und ungefährlichen Ausgangsmaterial in Form von Metalloxidpulver Metallnitrid und/oder Metallcarbid herzustellen.

Je nach Partialdruck der Elemente bei der Reaktion zum Reaktionsergebnisstoff entstehen MOₓN_{y} bzw. MOₓC_{y} oder MN_{y} bzw. MC_{y}, wobei M für das das Metalloxid bildende Metall, beispielsweise Zirconium oder Titan steht. Die genannten Partialdrücke lassen sich mittels Prozessparameter, wie beispielsweise Prozessdruck, Art des Prozessgases und Stromstärke zur Erzeugung des Plasmas, Flussrate des Prozessgases, Zuführrate des Ausgangsmaterials beeinflussen. Eine starke Reduktion wird insbesondere erreicht durch eine hohe Stromstärke sowie eine geringe Pulverförderrate.

Der stickstoffhaltige Reaktionsstoff kann beispielsweise als gasförmiger reiner Stickstoff oder als Luft ausgeführt sein. Der kohlenstoffhaltige Reaktionsstoff kann beispielsweise gasförmig als Kohlendioxid oder als Methan oder in fester Form als Stärke oder als ein Polymer ausgeführt sein.

Das bei der Reduktion entstehende reine Metall bzw. der Reaktionsergebnisstoff kann aus dem Plasmastrahl abgeschieden werden. Es kann beispielsweise in Form von Metall-Nanopulver abgeschieden werden. Die Abscheidung erfolgt insbesondere in einem vergleichweise geringen Abstand zu einer Austrittsdüse für den Plasmastrahl. Der Abstand beträgt insbesondere zwischen 100 und 400 mm. Der genannte Bereich zeichnet sich dadurch aus, dass einerseits die Reduktion des Metalloxids vollständig oder zumindest nahezu vollständig abgeschlossen ist und andererseits die Metallpartikel noch keine anderen Bindungen eingegangen sind. Der genannte Abstand ist insbesondere dann vorteilhaft, wenn Metall-Nanopulver hergestellt werden soll.

Das erfindungsgemässe Plasmaspritzverfahren ermöglicht eine kostengünstige Herstellung von Metall-, Nitrid- oder Carbid-Nanopulver. Ausserdem kann so bei entsprechenden Prozessbedingungen Nanopulver aus nicht schmelzbaren Nitrid- oder Carbidverbindungen, wie beispielsweise Siliciumnitrid (Si₃N₄) hergestellt werden.

Damit wird ein Verfahren zur Herstellung eines Metall-, Metallnitrid- oder Metallcarbidpulvers vorgeschlagen, bei dem ein Ausgangsmaterial in Form eines Metalloxids verwendet wird, das bei einem Prozessdruck von höchstens 1000 Pa in einen von einem Plasmagenerator erzeugten Plasmastrom eingebracht wird, in welchem das Ausgangsmaterial verdampft und dabei reduziert wird und entstehende Metall-, Metallnitrid- oder Metallcarbidpartikel als Pulver aus dem Prozessstrahl abgeschieden werden.

Die Abscheidung als Nanopulver erfolgt insbesondere dann, wenn sich der Plasmastrahl ausbilden kann, ohne auf eine Barriere, beispielsweise in Form eines Substrats zu treffen. Um die Abscheidung als Nanopulver zu fördern, kann der Plasmastrahl auch in einem definierten Bereich beispielsweise mittels eines Gasstroms gezielt abgekühlt werden, das Metall also quasi abgeschreckt werden und so die Bildung von Metall-Nanopulver gefördert werden. Der Gasstrom ist beispielsweise als ein Gasstrom aus einem Edelgas (z.B. Argon), einem Edelgasgemisch (z.B. Argon-Helium-Gemisch) oder einem Inertgas ausgeführt und ist beispielsweise quer zum Plasmastrahl orientiert. Zur Förderung der Abscheidung kann auch ein elektrostatischer Filter verwendet werden.

Die Korngrösse des entstehenden Nanopulvers kann insbesondere durch die Art des Plasmagases, welches Einfluss auf die Plasmatemperatur und die Plasmageschwindigkeit hat, und den Prozessdruck, welcher Einfluss auf die Kondensation des Nanopulvers hat, beeinflusst werden. Die Korngrösse wird insbesondere mit zunehmender Stromstärke und abnehmender Pulverförderrate kleiner.

Das bei der Reduktion entstehende reine Metall bzw. der Reaktionsergebnisstoff kann auch als eine Schicht auf einem Substrat aus dem Plasmastrahl abgeschieden werden. Unter einem Substrat soll in diesem Zusammenhang ein zu beschichtendes Werkstück, beispielsweise eine Turbinenschaufel verstanden werden. Dazu wird der Plasmastrahl auf das Substrat gerichtet, so dass sich auf dem Substrat eine Schicht aus dem reinen Metall oder dem Reaktionsergebnisstoff bildet. Damit ermöglicht das erfindungsgemässe Plasmaspritzverfahren eine kostengünstige Metall-, Nitrid- oder Carbid- Beschichtung eines Substrats. Ausserdem können mit dem erfindungsgemässen Verfahren bei der Einstellung entsprechender Prozessparameter Beschichtungen aus nicht schmelzbaren Nitrid- oder Carbidverbindungen, wie beispielsweise Siliciumnitrid (Si₃N₄) hergestellt werden. Dies ist mit bekannten Spritzmethoden zum Beschichten nicht oder nur begrenzt möglich.

Damit wird ein Verfahren zur Herstellung einer Schicht auf einem Substrat mit einem Plasmaspritzverfahren vorgeschlagen, bei dem ein Ausgangsmaterial in Form eines Metalloxids verwendet wird, das bei einem Prozessdruck von höchstens 1000 Pa in einen von einem Plasmagenerator erzeugten Plasmastrom eingebracht wird, in welchem das Ausgangsmaterial verdampft und dabei reduziert wird und entstehende Metall-, Metallnitrid- oder Metallcarbidpartikel als eine Schicht auf einem Substrat abgeschieden werden.

Die erzeugten Schichten weisen insbesondere eine Dicke zwischen 50 nm und 500 µm auf und können grossflächig sowohl dicht, als auch porös abgeschieden werden. Die porösen Schichten weisen insbesondere einen kolumnaren Aufbau auf. Der Aufbau und die Beschaffenheit der Schicht, sowie das Schichtwachstum können über die genannten Prozessparameter beeinflusst werden, wobei insbesondere eine höhere Pulverförderrate zu eher porösen Schichten führt.

Weitere Vorteile, Merkmale und Einzelheiten der Erfindung ergeben sich anhand der nachfolgenden Beschreibung von Ausführungsbeispielen sowie anhand der Zeichnungen, in welchen gleiche oder funktionsgleiche Elemente mit identischen Bezugszeichen versehen sind.

Dabei zeigen:
- Fig. 1: eine schematische Darstellung einer Plasmaspritzvorrichtung zur Herstellung von Nanopulver und
- Fig. 2: eine schematische Darstellung einer Plasmaspritzvorrichtung zur Erzeugung einer Schicht auf einem Substrat.

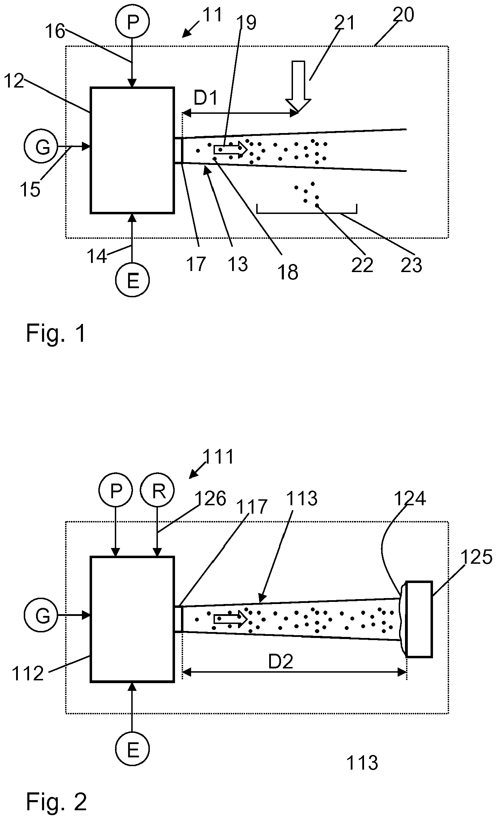

Gemäss Fig. 1 weist eine zur Durchführung eines erfindungsgemässen Verfahrens geeignete Plasmaspritzvorrichtung 11 einen an sich bekannten Plasmagenerator 12 mit einem nicht näher dargestellten Plasmabrenner zur Erzeugung eines Plasmas auf. In an sich bekannter Weise wird mit dem Plasmagenerator 12 aus einem Ausgangsmaterial P, einem Prozessgas G und elektrischer Energie E ein Plasmastrahl 13 erzeugt. Die Einspeisung dieser Komponenten E, G und P ist in Fig. 1 durch die Pfeile 14, 15, 16 symbolisiert. Der erzeugte Plasmastrahl 13 tritt durch eine Austrittsdüse 17 aus dem Plasmagenerator aus und transportiert das Ausgangsmaterial P in Form des Plasmastrahls 13 in dem Materialpartikel 18 in einem Plasma dispergiert sind. Dieser Transport ist durch einen Pfeil 19 symbolisiert.

Das Prozessgas G für die Erzeugung des Plasmas ist vorzugsweise ein Gemisch von Inertgasen, insbesondere ein Gemisch von Argon, Wasserstoff und Helium.

Die Plasmaspritzvorrichtung 11 ist in einer Prozesskammer 20 angeordnet, in der mittels nicht dargestellter Pumpen ein definierter Prozessdruck eingestellt werden kann. Bei der Durchführung des erfindungsgemässen Verfahrens wird ein Prozessdruck von weniger als 1000 Pa, insbesondere zwischen 100 und 400 Pa eingestellt. Auf Grund des genannten Prozessdrucks ergibt sich ein verhältnismässig langer Plasmastrahl mit einer Länge zwischen 1 und 2,5 m.

Speziell wird mit der in Fig. 1 dargestellten Plasmaspritzvorrichtung 11 ein Plasmaspritz-Gasabscheidungsverfahren (PS-PVD) durchgeführt. Bei diesem Verfahren wird das Ausgangsmaterial P, das aus Titanoxid (TiO₂), Zirconiumoxid (ZrO₂), Hafniumoxid (Hf₂O₃) oder Siliziumoxid (SiO₂) in Pulverform besteht, mittels eines Trägergases beispielsweise in Form von Argon in das vom Plasmagenerator 12 erzeugte Argon-Helium-Plasma und damit in den Plasmastrahl 13 eingebracht.

Das dadurch entstehende Plasmagas dehnt sich in und nach Austritt aus der Austrittsdüse 17 des Plasmagenerators 12 aufgrund der hohen Temperatur des Plasmas von 10.000 bis 20.000 Kelvin aus und beschleunigt auf Überschallgeschwindigkeit. Im Plasmastrahl 13 verdampft auf Grund der hohen Temperatur und des geringen Drucks das im Ausgangsmaterial P enthaltende Metalloxid. Dabei kommt es auf Grund des niedrigen Partialdrucks des Sauerstoffs zu einem Sauerstoffverlust, also zu einer Reduktion des Metalloxids, so dass das Metall nach der Reduktion in oder nahezu in Reinform im Plasmastrom vorliegt.

Das Ausgangsmaterial P wird mit einer vergleichsweise niedrigen Zuführrate zugeführt. Die Zuführrate liegt insbesondere in einem Bereich zwischen 0,1 und 5 g/min.

Der für die Erzeugung des Plasmas eingestellte Strom hat dabei eine Stromstärke zwischen ca. 1000 und 3000 A, insbesondere zwischen 2200 und 3000 A.

Das Ausgangsmaterial P wird als Pulverstrahl mit einem Fördergas, vorzugsweise Argon oder ein Helium-Argon-Gemisch in das Plasma injiziert. Die Flussrate des Fördergases beträgt vorzugsweise 5 bis 40 SLPM (Standard Litre Per Minute), insbesondere 10 bis 25 SLPM.

Das Prozessgas für die Erzeugung des Plasmas ist vorzugsweise ein Gemisch von Inertgasen, insbesondere ein Gemisch von Argon Ar, Helium He und Wasserstoff H. In der Praxis hat sich ein Gesamtgasfluss zwischen 50 und 200 SLPM, insbesondere 90 bis 120 SLPM bewährt. Davon sind insbesondere ca. 1/3 Argon und 2/3 Helium. Ausserdem ist ein Anteil von bis zu 10 SLPM Wasserstoff denkbar.

Um eine Abscheidung der entstanden Metallpartikel in Form eines Nanopulvers zu fördern, wird der Plasmastrahl 13 und damit auch die im Plasmastrahl 13 enthaltenden Metallpartikel 18 durch einen quer zum Plasmastrom 13 orientierten Gasstrom 21 gezielt abgekühlt und das Metall damit quasi abgeschreckt. Es wird eine Kondensation der gasförmigen Metallpartikel 18 angestossen und es bildet sich Nanopulver 22, das sich in einer Auffangvorrichtung 23 sammelt.

Der Gasstrom 21 hat dabei einen Abstand D1 zwischen 100 und 400 mm, insbesondere 150 mm von der Austrittsdüse 17.

In Fig. 2 ist eine Plasmaspritzvorrichtung 111 zur Erzeugung einer Schicht 124 auf einem Substrat 125 dargestellt. Der Aufbau der Plasmaspritzvorrichtung 111 entspricht in weiten Teilen der Plasmaspritzvorrichtung 11 aus Fig. 1, weshalb hauptsächlich auf die Unterschiede der beiden Plasmaspritzvorrichtungen eingegangen wird.

Einem Plasmagenerator 112 der Plasmaspritzvorrichtung 111 wird zusätzlich zum Ausgangsmaterial P, das wiederum als Titanoxid (TiO₂) oder Zirconiumoxid (ZrO₂) in Pulverform ausgeführt ist, ein Reaktionsstoff R zugeführt, dessen Einspeisung durch einen Pfeil 126 symbolisiert ist. Der Reaktionsstoff enthält Stickstoff oder Kohlenstoff, so dass das bei der Reduktion des Metalloxids entstehende reine Metall zu einem Metallnitrid oder einem Metallcarbid reagieren kann. Der stickstoffhaltige Reaktionsstoff kann beispielsweise als gasförmiger reiner Stickstoff ausgeführt sein. Der kohlenstoffhaltige Reaktionsstoff kann beispielsweise gasförmig als Kohlendioxid oder als Methan oder in fester Form als Stärke oder als ein Polymer ausgeführt sein. Wenn der Reaktionsstoff in fester Form zugeführt wird, so erfolgt das auch mit einem Transportgas. Dabei kann es sich um das selbe Transportgas wie für den Ausgangsmaterial P oder ein davon abweichendes Transportgas handeln.

Nach der oben beschriebenen Reduktion des Metalloxids des Ausgangsmaterials P findet im Plasmastrom 113 eine Reaktion des reinen Metalls mit dem Reaktionsstoff R zu einem Reaktionsergebnisstoff statt. Betrachtet man das gesamte Verfahren, so wird zur Gewinnung des Reaktionsergebnisstoffs der im Metalloxid gebundene Sauerstoff durch Stickstoff oder Kohlenstoff des Reaktionsstoffs R ersetzt.

Je nach Partialdruck der Elemente bei der Reaktion zum Reaktionsergebnisstoff entstehen MOₓN_{y} bzw. MOₓC_{y} oder MN_{y} bzw. MC_{y}, wobei M für das das Metalloxid bildende Metall, also Zirconium oder Titan steht. Die genannten Partialdrücke lassen sich mittels Prozessparameter, wie beispielsweise Prozessdruck, Art des Prozessgases und Stromstärke zur Erzeugung des Plasmas, Flussrate des Prozessgases, Zuführrate des Ausgangsmaterials beeinflussen.

In einem Abstand D2 von einer Austrittsdüse 117 des Plasmagenerators 112 ist das Substrat 125 angeordnet. Der Abstand D2 kann grösser gewählt werden als der Abstand D1 in Fig. 1, er beträgt insbesondere zwischen 500 und 2000 mm. Der genannte Reaktionsergebnisstoff scheidet sich am Substrat 125 als Schicht 124 ab. Die Schicht 124 kann eine Dicke zwischen 50 nm und 500 µm aufweisen und sowohl dicht, als auch porös ausgebildet sein. Der Aufbau und die Beschaffenheit der Schicht, sowie das Schichtwachstum können über die genannten Prozessparameter beeinflusst werden.

Es ist selbstverständlich auch möglich, dass bei der Erzeugung von Nanopulver gemäss Fig. 1 ein Reaktionsstoff zugeführt wird und damit ein Nitrid- oder Carbid-Nanopulver erzeugt wird. Ebenfalls ist es möglich, bei der Erzeugung einer Schicht auf einem Substrat gemäss Fig. 2 auf die Zuführung eines Reaktionsstoffs zu verzichten und damit eine Schicht aus reinem Metall zu erzeugen. Um zufriedenstellende Ergebnisse zu erzielen sind unter Umständen gewisse Anpassungen der Prozessparameter notwendig.

## Patentansprüche

1. Plasmaspritzverfahren,
bei welchem ein Ausgangsmaterial (P) bei einem Prozessdruck in einer Prozesskammer (20) von höchstens 1000 Pa in einen von einem Plasmagenerator (12, 112) erzeugten Plasmastrahl (13, 113) eingebracht wird,
wobei das Ausgangsmaterial (P) ein Metalloxid enthält, welches im Plasmastrahl (13, 113) verdampft und dabei reduziert wird.

2. Plasmaspritzverfahren nach Anspruch 1,
**dadurch gekennzeichnet, dass**
das Ausgangsmaterial (P) ausschliesslich aus Metalloxid eines einzigen Metalls besteht.

3. Plasmaspritzverfahren nach Anspruch 2,
**dadurch gekennzeichnet, dass**
das Ausgangsmaterial (P) als Pulver in den Plasmastrahl (13, 113) eingebracht wird.

4. Plasmaspritzverfahren nach Anspruch 1, 2 oder 3,
**dadurch gekennzeichnet, dass**
das Metalloxid als Zirconiumoxid, Hafniumoxid oder Titanoxid ausgeführt ist.

5. Plasmaspritzverfahren nach einem der Ansprüche 1 bis 4,
**dadurch gekennzeichnet, dass**
der Prozessdruck höchstens 400 Pa beträgt.

6. Plasmaspritzverfahren nach einem der Ansprüche 1 bis 5
**dadurch gekennzeichnet, dass**
eine Zuführrate des Ausgangsmaterials (P) in einem Bereich zwischen 0,5 bis 5 g/min liegt.

7. Plasmaspritzverfahren nach einem der Ansprüche 1 bis 6,
**dadurch gekennzeichnet, dass**
das bei der Reduktion des Metalloxids entstehende Metall aus dem Plasmastrahl (13) abgeschieden wird.

8. Plasmaspritzverfahren nach Anspruch 7,
**dadurch gekennzeichnet, dass**
die Metallpartikel in einem Abstand (D1) zwischen 100 und 400 mm von einer Austrittsdüse (17) für den Plasmastrahl entfernt abgeschieden werden.

9. Plasmaspritzverfahren nach einem der Ansprüche 1 bis 6,
**dadurch gekennzeichnet, dass**
ein zusätzlicher Reaktionsstoff (R) in den Plasmastrahl (113) eingebracht wird und so eine Reaktion zwischen dem reduzierten Metalloxid und dem Reaktionsstoff (R) zu einem Reaktionsergebnisstoff ablaufen kann.

10. Plasmaspritzverfahren nach Anspruch 9,
**dadurch gekennzeichnet, dass**
der Reaktionsstoff (R) Stickstoff und/oder Kohlenstoff enthält.

11. Plasmaspritzverfahren nach Anspruch 9 oder 10,
**dadurch gekennzeichnet, dass**
Partikel des Reaktionsergebnisstoffs aus dem Plasmastrahl (113) abgeschieden werden.

12. Plasmaspritzverfahren nach Anspruch 11,
**dadurch gekennzeichnet, dass**
die Partikel des Reaktionsergebnisstoffs in einem Abstand (D2) zwischen 500 und 2000 mm von einer Austrittsdüse (117) für den Plasmastrahl entfernt abgeschieden werden.

13. Plasmaspritzverfahren nach Anspruch 7, 8, 11 oder 12,
**dadurch gekennzeichnet, dass**
die Metallpartikel oder die Partikel des Reaktionsergebnisstoffs in Form eines Pulvers (22) abgeschieden werden.

14. Plasmaspritzverfahren nach Anspruch 7, 8, 11 oder 12,
**dadurch gekennzeichnet, dass**
die Metallpartikel oder die Partikel des Reaktionsergebnisstoffs in Form einer Schicht (124) auf einem Substrat (125) abgeschieden werden.
